# EUROPEAN PATENT SPECIFICATION

(11) **EP 2 571 106 B1**
(45) Date of publication and mention of the grant of the patent: **02.03.2016**
(21) Application number: 12250142.2
(22) Date of filing: 30.08.2012
(51) Int. Cl.: H01R 107/00, H01R 24/58, H01R 13/52

(54) **Waterproof connector**
Wasserdichter Steckverbinder
Connecteur étanche

(30) Priority: 14.09.2011 JP 2011201038
(43) Date of publication of application: 20.03.2013
(73) Proprietor: Hosiden Corporation, Yao-shi, Osaka 581-0071 (JP)
(72) Inventor: Nagata, Takayuki, Yao-shi Osaka 581-0071 (JP); Sasaki, Daisuke, Yao-shi Osaka 581-0071 (JP)
(74) Representative: Beresford, Keith Denis Lewis

(56) References cited:
- EP-A1- 2 175 530
- US-A1- 2011 195 611
- US-B1- 7 963 786

## Description

The present invention relates to waterproof connectors

There is known a connector as disclosed in JP Publication No. 2004-87185 serving as an earphone jack for use in portable terminals such as smartphones. The connector is provided with a cover fitting thereover to prevent water intrusion into the portable terminal through the connector.

Such a connector may allow water intrusion into the portable terminal when the portable terminal is inadvertently exposed to water in the state where the cover is not properly engaged with the connector.

United States patent No. US 7963786 B1 discloses an audio jack comprising an insulating housing, a plurality of contacts, a waterproof covering body and a retaining shell. The insulating housing has an inserting hole and a plurality of contact-receiving grooves. The contacts are separately inserted into the contact-receiving grooves. The waterproof covering body encompasses the insulating housing and is made of elastic material. The waterproof covering body has a ring-shaped protruding edge extending out of an end surface of the insulating housing. The retaining shell is mounted on the outside of the waterproof covering body.

The present invention is devised to provide a waterproof connector.

A waterproof connector according to the invention is defined in claim 1.

According to invention, the insulating resin molded portion covers the boundary between the body and the cover, the boundary between the body and the connecting portion of the contact, and the boundary between the cover and the connecting portion of the contact. Thus, the connector is capable of preventing water intrusion from between the cover and the body, between the body and the connecting portion of the contact, and between the cover and the connecting portion of the contact. Moreover, the connector can provide such waterproof property at low costs because the molded portion of the insulating resin can be manufactured by outsert molding or in a similar method.

The connecting hole may pass through the body in a first direction. The body may further include a first end in a second direction orthogonal to the first direction, a second end in the second direction on the opposite side from the first end, a first recess provided in the first end, the first recess having a bottom provided with the housing hole or slit, and a second recess provided in the second end. The cover may include a first blocking portion to block the connecting hole, and a second blocking portion housed in the first recess so as to block the housing hole or slit. The molded portion may include first, second and third molded portions. The first molded portion may cover the first blocking portion and bond the first blocking portion to the body. The first molded portion may include a first end in the second direction and a second end in the second direction on the opposite side from the first end. The second molded portion may be continuous with the first end of the first molded portion and filled in the first recess of the body. The second molded portion may cover the second blocking portion and bond the second blocking portion to the body. The third molded portion may be continuous with the second end of the first molded portion and filled in the second recess of the body.

In this aspect of the invention, the first molded portion covers the first blocking portion and bonds the first blocking portion to the body; the second molded portion is filled in the first recess of the first end of the body to cover the second blocking portion and bond the second blocking portion to the body; and the third molded portion is filled in the second recess in the second end of the body. That is, the second and third molded portions are provided such as to hold the body in the second direction. This aspect of invention can improve the bonding strength of the molded portion to the cover and the body.

The body may further include a third end in a third direction orthogonal to the first and second directions, and a fourth end in the third direction on the opposite side from the third end. The first molded portion may further include a third end in the third direction, and a fourth end in the third direction on the opposite side from the third end. The molded portion may further include fourth and fifth molded portions. The fourth molded portion may be continuous with the third end of the first molded portion and cover the third end of the body. The fifth molded portion may be continuous with the fourth end of the first molded portion and cover the fourth end of the body.

In this aspect of the invention, the fourth molded portion communicating with the third end of the first molded portion covers the third end of the body, and the fifth molded portion communicating with the fourth end of the first molded portion covers the fourth end of the body. That is, since the fourth and fifth molded portions hold the body in the third direction, the bonding strength of the molded portion to the cover and the body can be improved.

One end surface in the third direction of the second blocking portion may be flush with an end surface of the third end of the body, and the fourth molded portion may bond the end surface of the second block portion to the end surface of the third end of the body. The other end surface in the third direction of the second blocking portion may be flush with an end surface of the fourth end of the body, and the fifth molded portion may bond the end surface of the second block portion to the end surface of the fourth end of the body.

The connecting portion of the contact may pass through the second, fourth or fifth molded portion. In this case, the second, fourth or fifth molded portion covers a boundary between the connecting portion of the contact and the body and a boundary between the connecting portion of the contact and the cover.

At least one of the body and the cover may be provided with a lead hole for interconnecting between the housing hole or slit and the outside of the body and the cover. The connecting portion of the contact may protrude through the lead hole to the outside of the body and the cover.

It is preferable that at least one of the body, the cover and the molded portion be made of a polyamide resin. This aspect of the invention can improve the waterproof property of the connector because polyamide resins generally exhibit favorably good adhesion to other resin materials and metals. This aspect of the invention can also improve twisting strength of the connector because polyamide resins are superior to other resin materials in toughness.

The connector may further include a ring-shaped gasket to fit around the body. In this aspect of the invention, the ring-shaped gasket fitted around the body may be interposed between the connector and a housing of an electronic device with the connector installed. Therefore, this aspect of the invention can prevent water intrusion from between the connector and the housing of the electronic device.

An electronic device of the invention includes the connector according one of the above-mentioned aspects described above.

The invention will now be described by way of example only and without limitation by reference to the drawings, in which:
Fig. 1A is a front, top, right side perspective view of a connector in accordance with Embodiment 1 of the invention, illustrating a molded portion as transparent.
Fig. 1B is a back, top, left side perspective view of the connector, illustrating a molded portion as transparent.
Fig. 1C is a front, bottom, right side perspective view of the connector, illustrating the molded portion as transparent.
Fig. 1D is a back, bottom, left side perspective view of the connector, illustrating the molded portion as transparent.
Fig. 2A is a sectional view of the connector taken along 2A-2A in Fig. 1A, with a gasket removed.
Fig. 2B is a sectional view of the connector taken along 2B-2B in Fig. 1A, with the gasket removed.
Fig. 2C is a sectional view of the connector taken along 2C-2C in Fig. 1A, with the gasket removed.
Fig. 2D is a sectional view of the connector taken along 2D-2D in Fig. 1A, with the gasket removed.
Fig. 3A is an exploded, back, bottom, right side perspective view of the connector.
Fig. 3B is an exploded, front, bottom, left side perspective view of the connector.
Fig. 4A is a front, top, right side perspective view of a connector in accordance with Embodiment 2 of the invention, illustrating a molded portion as transparent.
Fig. 4B is a back, top, left side perspective view of the connector, illustrating the molded portion as transparent.
Fig. 4C is a front, bottom, right side perspective view of the connector, illustrating the molded portion as transparent.
Fig. 4D is a back, bottom, left side perspective view of the connector, illustrating the molded portion as transparent.
Fig. 5A is a sectional view of the connector taken along 5A-5A in Fig. 4A, with a gasket removed.
Fig. 5B is a sectional view of the connector taken along 5B-5B in Fig. 4A, with the gasket removed.
Fig. 5C is a sectional view of the connector taken along 5C-5C in Fig. 4A, with the gasket removed.
Fig. 5D is a sectional view of the connector taken along 5D-5D in Fig. 4A, with the gasket removed.
Fig. 6A is an exploded, back, bottom, right side perspective view of the connector.
Fig. 6B is an exploded, front, bottom, left side perspective view of the connector.
Fig. 7 is a schematic bottom view of a modification example of the connector of Embodiment 1.

In this document, relative spatial terms such as "lower", "upward", "top", "bottom", "left", "right", "front", "rear", etc., are used for the convenience of the skilled reader and refer to the orientation of the connector and its constituent parts as depicted in the drawings. No limitation is intended by use of these terms, either in use of the invention, during its manufacture, shipment, custody, or sale, or during assembly of its constituent parts or when incorporated into or combined with other apparatus.

Embodiments 1 and 2 of the invention will be described below.

### Embodiment 1

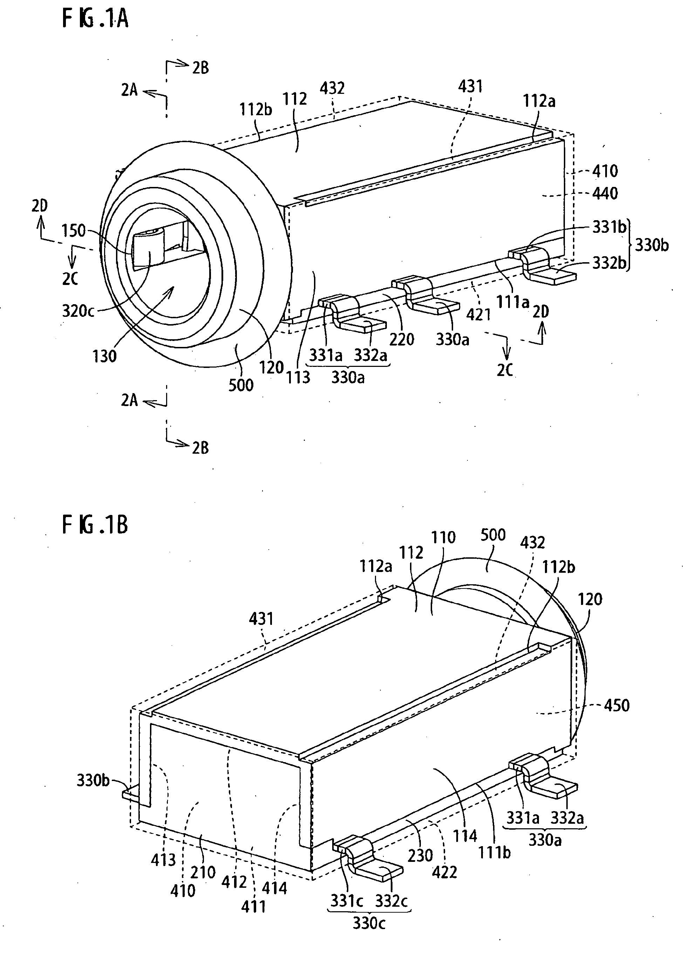

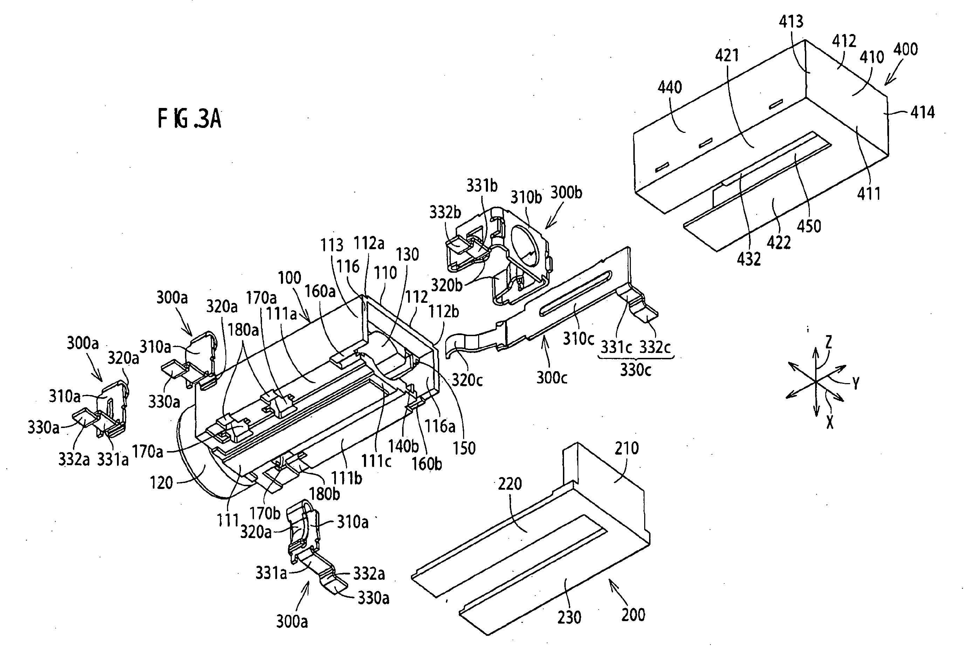

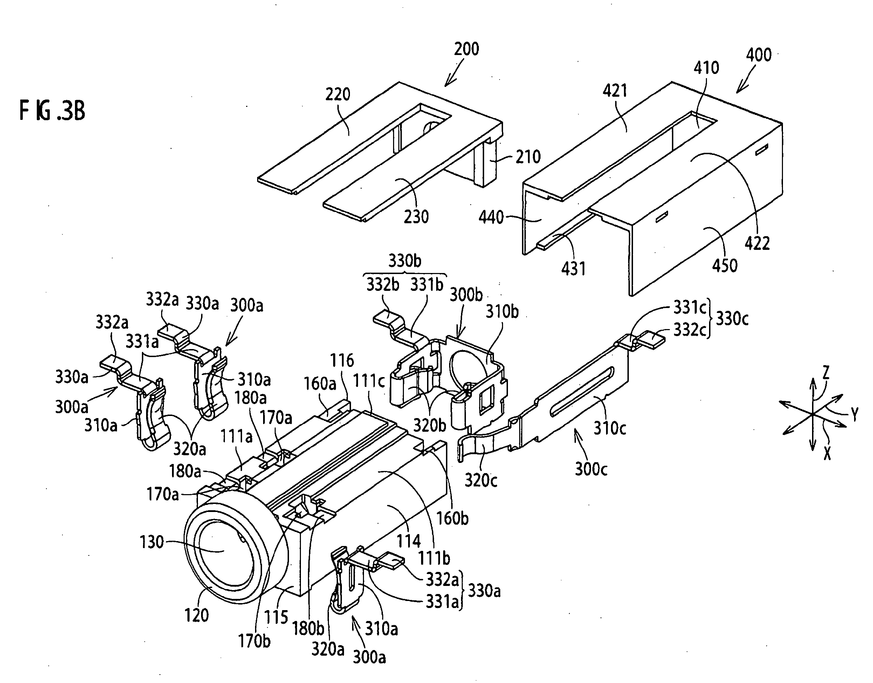

First, a connector in accordance with Embodiment 1 of the invention will be described with reference to Fig. 1A to Fig. 3B. The connector shown in Fig. 1A to Fig. 2B is a female electrical connector or jack for mating with a plug (not shown). The connector includes a body 100, a cover 200, three contacts 300a, a contact 300b, a contact 300c, a molded portion 400, and a gasket 500. Each of these constituents of the connector will be described below in detail. It should be noted that Fig. 3A and Fig. 3B indicate X, Y, and Z directions, which are a width or left to right direction, a front-back direction, and a vertical or bottom to top direction, respectively, of the connector. The Y direction is orthogonal to the X direction, and the Z direction is orthogonal to the X and Y directions. The X, Y, and Z directions corresponds to a third direction, a first direction, and a second direction, respectively, in the claims, and the Y direction also corresponds to a longitudinal direction of the body 100 in the claims. A mating plug (not shown) has a cylindrical connecting portion, around which a third electrode, a second electrode, a first electrode, and an earth electrode are formed in this order from a distal end side of the connecting portion.

The body 100 is made of an insulating resin such as a polyamide resin. The body 100 includes a main body 110 and a ring 120. The main body 110 is of a substantially rectangular parallelepiped shape as shown in Fig. 1A to Fig. 3B, including a first end 111 in the Z direction, a second end 112 in the Z direction on the opposite side from the first end 111, a third end 113 in the X direction, a fourth end 114 in the X direction on the opposite side from the third end 113, a fifth end 115 in the Y direction, and a sixth end 116 in the X direction on the opposite side from the fifth end 115. The ring 120 is a cylinder connected to the fifth end 115 of the main body 110. The gasket 500 made of a silicon resin is fitted around the ring 120. The gasket 500 may be interposed between the ring 120 and a housing (not shown) of an electronic device for mounting the connector to prevent intrusion of water, dusts and the like from between the ring 120 and the housing. The gasket 500 may be omitted. The gasket may be fitted around the main body 110.

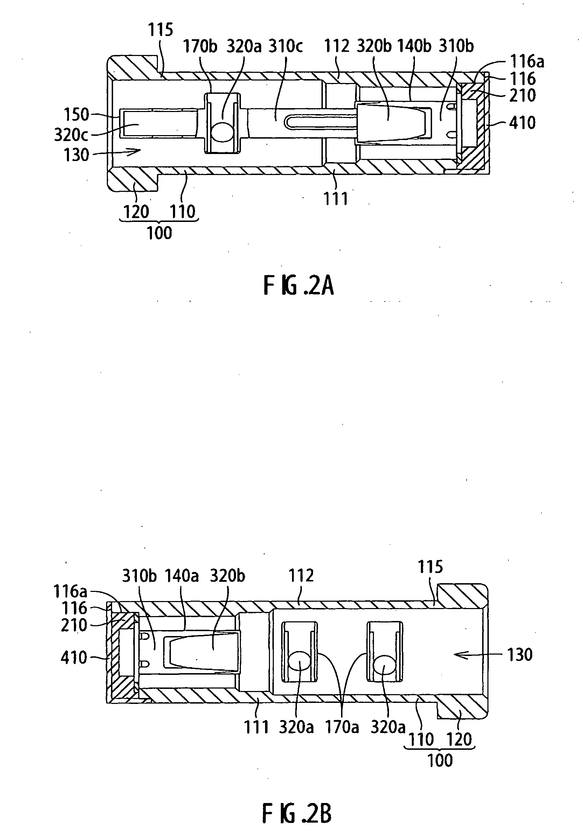

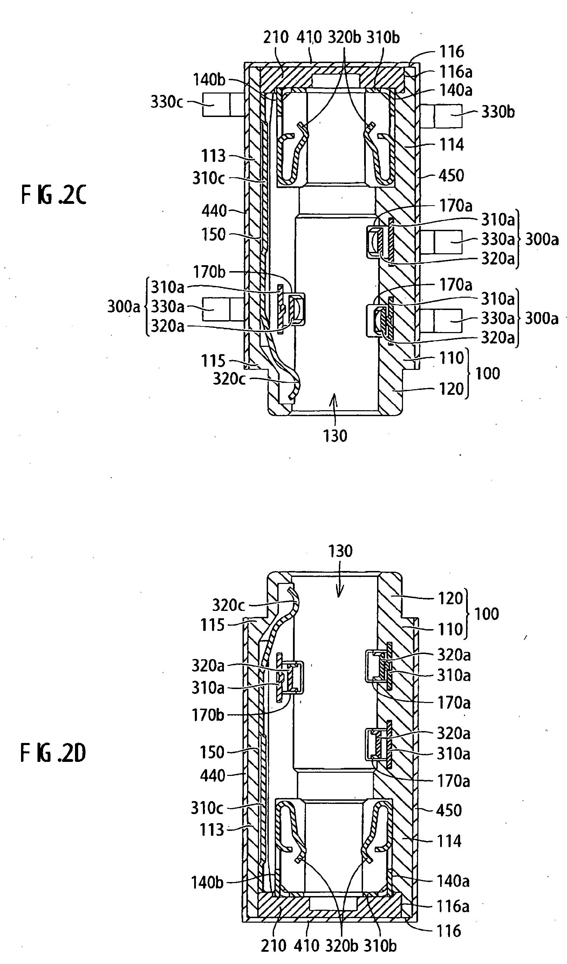

The body 100 is further provided with a connecting hole 130, slits 140a and 140b, a slit 150, a lead hole 160a and 160b, a pair of housing holes 170a, a housing hole 170b, a pair of lead holes 180a, a lead hole 180b. More particularly, the connecting hole 130 passes through the main body 110 and the ring 120 in the Y direction as shown in Fig. 2C and Fig. 2D. The slits 140a, 140b extend in the Y direction on opposite sides in the X direction of the connecting hole 130 of the main body 110. The slits 140a, 140b are open on the side of the connecting hole 130 and communicate with the connecting hole 130. The slit 150 extends in the Y direction on the outer side of the slit 140b of the main body 110. The slit 150 is open on the side of the connecting hole 130 and communicates with the slit 140b and the connecting hole 130. A housing recess 116a is formed in the sixth end 116 of the main body 110. The connecting hole 130, the slits 140a, 140b and the slit 150 are open on a side in the Y direction (i.e. on the rear side) to the outside of the body 100 through the housing recess 116a.

As shown in Fig. 3A and Fig. 3B, first recesses 111a, 111b extend in the longitudinal or Y direction along opposite ends in the widthwise or X direction of the first end 111 of the main body 110. The lead hole 160a is formed in the bottom of the first recess 111a and communicates with the slit 140a. The bottom of the first recess 111a is also provided with the pair of housing holes 170a aligning in the Y direction and the pair of lead holes 180a communicating with the respective housing holes 170a. The lead hole 160a is open on the side of the third end 113 of the main body 110 and interconnects between the slit 140a and the outside of the main body 110. The housing holes 170a are open on the other side (lower side or bottom side) in the Z direction. The lead holes 180a are open on the side of the third end 113 of the main body 110 and interconnect between the housing holes 170a and the outside of the main body 110.

The lead hole 160b is formed in the bottom of the first recess 111b and communicates with the slit 140b. The bottom of the first recess 111b is also provided with the housing hole 170b and the lead hole 180b communicating with each other. The lead hole 160b is open on the side of the fourth end 114 of the main body 110 and interconnects between the slit 140b and the outside of the main body 110. The housing hole 170b is open on the other side (lower side) in the Z direction. The lead hole 180b is open on the side of the fourth end 114 of the main body 110 and interconnects between the housing hole 170b and the outside of the main body 110.

The first end 111 of the main body 110 is provided on one end in the Y direction with a recess 111c communicating with the first recesses 111a, 111b. The second end 112 of the main body 110 is provided along opposite ends in the X direction with second recesses 112a, 112b extending in the Y direction, as shown in Fig. 1A and Fig. 1B

The contacts 300a are formed of electrically conductive metal plates. The contacts 300a each includes a fixed portion 310a, a contact portion 320a, and a connecting portion 330a. The fixed portion 310a is a substantially rectangular plate and has a protrusion on each end in its width direction. The width of the fixed portion 310a including the protrusions is slightly larger than each width of the housing holes 170a, 170b of the body 100. Accordingly, the fixed portions 310a are fittingly held in the housing holes 170a, 170b, respectively. The contact portion 320a is a plate spring continuous with one end in the Z direction of the fixed portion 310a and is folded toward the other end in the Z direction. The contact portion 320a is accommodated in each of the housing holes 170a, 170b. When accommodated, the contact portion 320a is partly placed in the connecting hole 130 for elastic contact with the first and second electrodes of an inserted plug. The connecting portion 330a is a plate continuous with the other end in the Z direction (heightwise or bottom-top direction) of the fixed portion 310a and bent substantially perpendicularly to the fixed portion 310a. The connecting portion 330a has a basal end 331a and a distal end 332a continuous with each other. The basal ends 331a pass through the lead holes 180a, 180b of the main body 110 and protrude toward the third end 113 and the fourth end 114 of the main body. The distal end 332a is formed step-like.

The contact 300b is a spring clip formed of an electrically conductive metal plate. The contact 300b includes a fixed portion 310b, a pair of contact portions 320b, and a connecting portion 330b. The fixed portion 310b is a generally U-shaped plate. The fixed portion 310b includes a first plate and a pair of second plates. The second plates are provided on opposite ends in the X direction of the first plate and bent substantially perpendicularly to the first plate. A protrusion is provided at one end in the Z direction of each of the second plates of the fixed portion 310b. The Z direction dimension of the fixed portion 310b including the protrusions is slightly larger than each Z direction dimension of the slits 140a, 140b of the body 100. Accordingly, the fixed portion 310b is fittingly held in the slits 140a, 140b. The first plate of the fixed portion 310b is disposed so as to block one side in the Y direction of the connecting hole 130 of the main body 110. The contact portions 320b are plate springs continuous with the distal end of the second plate of the fixed portion 310b and folded toward the rear side (one side in the Y direction). The distal ends of the contact portions 320b are received in the connecting hole 130 for elastic contact with the third electrode of the plug. The connecting portion 330b is a plate continuous with the other end in the Z direction of one of the second plates of the fixed portion 310b and bent substantially perpendicularly to the second plate. The connecting portion 330b has a basal end 331b and a distal end 332b continuous with each other. The basal end 331b pass through the lead hole 160a of the main body 110 and protrudes toward the third end 113 of the main body 110. The distal end 332b is formed step-like.

The contact 300c is an earth spring formed of an electrically conductive metal plate. The contact 300c includes a fixed portion 310c, a contact portion 320c, and a connecting portion 330c. The fixed portion 310c is a substantially rectangular plate extending in the Y direction and provided with a protrusion at its end in the Z direction. The Z direction dimension of the fixed portion 310c including the protrusion is slightly larger than the Z direction dimension of the slit 150 of the body 100. Accordingly, the fixed portion 310c is fittingly held in the slit 150. The contact portion 320c is a plate spring continuous with a distal end (the other end in the Y direction) of the fixed portion 310c and is curved inward. The distal end of the contact portion 320c is placed in the connecting hole 130 for elastic contact with the earth electrode of the plug. The connecting portion 330c is a plate continuous with the other end in the Y direction of the fixed portion 310c and bent substantially perpendicularly to the fixed portion 310c. The connecting portion 330c includes a basal end 331 c and a distal end 332c continuous with each other. The basal end 331c passes through the lead hole 160b of the main body 110 and protrudes toward the fourth end 114 of the main body 110. The distal end 332c is formed step-like. The lower surfaces of the distal ends 332a, 332b, 332c are set to be in the same height level.

The cover 200 is made of an insulating resin such as a polyamide resin. The cover 200 includes a first blocking portion 210 and second blocking portions 220, 230. The first blocking portion 210 is a rectangular plate and is housed in the housing recess 116a of the body 100. The first blocking portion 210 blocks one side in the Y direction of each of the connecting hole 130 and the slits 140a, 140b, 150 and covers the fixed portions 310b, 310c and the contact portions 320b, 320c of the contacts 300b, 300c.

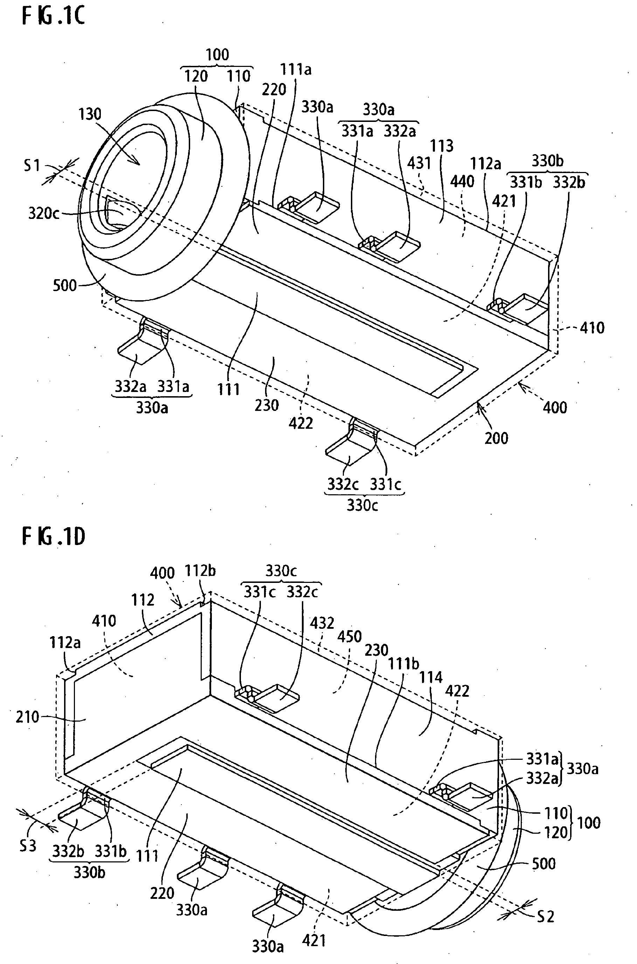

The second blocking portions 220, 230 are generally rectangular plates continuous with the lower end (the other end in the Z direction) of the first blocking portion 110 and extend in the Y direction. The second blocking portions 220, 230 has an integrated basal end. The second blocking portion 220 fits in the first recess 111 a of the main body 110 so as to block the lead hole 160a, the housing holes 170a and the lead holes 180a and cover the fixed portions 310a and the contact portions 320a of the contacts 300a in the housing holes 170a. One end surface in the X direction of the second blocking portion 220 is flush with the end surface of the third end 113 of the main body 110. As shown in Fig. 1C, a gap S1 is provided between the other end face in the X direction of the second blocking portion 220 and the inner wall on the other side in the X direction of the first recess 111 a of the main body 110.

The second blocking portion 230 fits in the first recess 111b of the main body 110 so as to block the lead hole 160b, the housing hole 170b and the lead hole 180b and cover the fixed portion 310a and the contact portion 320a of the contact 300a in the housing hole 170b. The other end surface in the X direction of the second blocking portion 230 is flush with the end surface of the fourth end 114 of the main body 110. As shown in Fig. 1D, a gap S2 is provided between the one end surface in the X direction of the second blocking portion 230 and the inner wall on the one side in the X direction of the first recess 111b of the main body 110. As shown in Fig. 1D, a gap S3 is provided between the integrated basal end of the second blocking portions 220, 230 and the inner wall on other side in the Y direction of the recess 111c of the main body 110.

The molded portion 400 is formed by outsert molding an insulating resin such as a polyamide resin. The molded portion 400 includes a first molded portion 410, second molded portions 421, 422, third molded portions 431, 432, a fourth molded portion 440, and a fifth molded portion 450.

The first molded portion 410 is a rectangular plate, contacting and covering the sixth end 116 of the main body 110 and the first blocking portion 210 of the cover 200 and bonding the first blocking portion 210 to the sixth end 116 of the main body 110. That is, the first molded portion 410 covers and blocks a boundary between the sixth end 116 of the main body 110 and the first blocking portion 210 of the cover 200. The first molded portion 410 includes a first end 411 in the Z direction, a second end 412 in the Z direction on the opposite side from the first end 411, a third end 413 in the X direction, and a fourth end 414 in the X direction on the opposite side from the third end 413.

The second molded portions 421, 422 are rectangular plates continuous with the first end 411 of the first molded portion 410 and extend in the Y direction. The second molded portions 421, 422 are filled into the gaps S1, S2 of the first recesses 111a, 111b of the first end 111 of the main body 110 and the gap S3 of the recess 111c, contact and cover the second blocking portions 220, 230, and bond the second blocking portions 220, 230 to the main body 110. That is, the second molded portions 421, 422 cover and block boundaries between the second blocking portions 220, 230 and the first end 111 of the main body 110.

The third molded portions 431, 432 are rectangular plates continuous with the second end 412 of the first molded portion 410 and extend in the Y direction. The third molded portions 431, 432 are filled into the second recesses 112a, 112b of the main body 110.

The fourth molded portion 440 is a rectangular plate continuous with the third end 413 of the first molded portion 410 and extends in the Y direction. The fourth molded portion 440 interconnects between the second molded portion 421 and the third molded portion 431. The fourth molded portion 440 contacts and covers the third end 113 of the main body 110 and one side in the X direction of the second blocking portion 220 and bonds one end surface in the X direction of the second blocking portion 220 to the end surface of the third end 113 of the main body 110. The basal ends 331 a of the connecting portions 330a of the two contacts 300a on one side in the X direction, and the basal end 331b of the connecting portion 330b of the contact 300b pass through the fourth molded portion 440. That is, the fourth molded portion 440 covers and blocks a boundary between the second blocking portion 220 and the third end 113 of the main body 110, boundaries between the basal ends 331 a of the connecting portions 330a of the two contacts 300a and the second blocking portion 220, the boundaries between the basal ends 331a of the connecting portions 330a of the contacts 300a and the third end 113 of the main body 110, a boundary between the basal end 331b of the connecting portion 330b of the contact 300b and the second blocking portion 220, and a boundary between the basal end 331b of the connecting portion 330b of the contact 300b and the third end 113 of the main body 110.

The fifth molded portion 450 is a rectangular plate continuous with the fourth end 414 of the first molded portion 410 and extends in the Y direction. The fifth molded portion 450 interconnects between the second molded portion 422 and the third molded portion 432. The fifth molded portion 450 contacts and covers the fourth end 114 of the main body 110 and the other side in the X direction of the second blocking portion 230, and bonds the other end surface in the X direction of the second blocking portion 230 to the end surface of the fourth end 114 of the main body 110. The basal end 331 a of the connecting portion 330a of the one contact 300a on the other side in the X direction and the basal end 331 c of the connecting portion 330c of the contact 300c pass through the fifth molded portion 450. That is, the fifth molded portion 450 covers and blocks a boundary between the second blocking portion 230 and the fourth end 114 of the main body 110, a boundary between the basal end 331a of the connecting portion 330a of the one contact 300a and the second blocking portion 230, a boundary between the basal end 331 a of the connecting portion 330a of the one contact 300a and the fourth end 114 of the main body 110, a boundary between the basal end 331 c of the connecting portion 330c of the contact 300c and the second blocking portion 230, a boundary between the basal end 331 c of the connecting portion 330c of the contact 300c and the fourth end 114 of the main body 110.

The connector with the above-mentioned configuration may be manufactured in the following steps. The first step is to prepare the body 100 fabricated by injection-molding insulating resin, and the contact 300a fabricated by press-molding a metal plate. After that, the fixed portions 310a of the contacts 300a are pressed into the housing holes 170a, 170b of the body 100, and the contact portions 320a of the contacts 300a are inserted into the housing holes 170a, 170b. Then, the fixed portions 310a are held in the housing holes 170a, 170b of the body 100. The contact portions 320a are placed through the housing holes and then into the connecting hole 130 of the body 100. The basal ends 331 a of the connecting portions 330a of the contacts 300a are inserted into the lead holes 180a, 180b of the body 100, and the distal ends 332a protrude from the lead holes 180a, 180b to the outside of the body 100.

The next step is to prepare the contact 300c by press-molding a metal plate. The contact portion 320c of the contact 300c is inserted into the slit 150 of the body 100, and the fixed portion 310c is pressed into the slit 150. Then, the fixed portion 310c is held in the slit 150. The distal end of the contact portion 320c is placed through the slit 150 and then into the connecting hole 130. The basal end 331c of the connecting portion 330c of the contact 300c is inserted into the lead hole 160b of the body 100, and the distal end 332c protrudes from the lead hole 160b to the outside of the body 100.

The next step is to prepare the contact 300b by press-molding a metal plate. The pair of second plates of the fixed portion 310b of the contact 300b are pressed into the slits 140a, 140b of the body 100. Then, distal ends of the pair of contact portions 320b of the contact 300b are placed through the slits 140a, 140b and then into the connecting hole 130. The basal end 331b of the connecting portion 330b of the contact 300b is inserted into the lead hole 160a of the body 100, and the distal end 332b protrudes from the lead hole 160a to the outside of the body 100.

The next step is to prepare the cover 200 by injection-molding the insulating resin. The first blocking portion 210 of the cover 200 is fitted in the housing recess 116a of the body 100, and the second blocking portions 220, 230 of the cover 200 are fitted into the first recesses 111a, 111b of the body 100. Then, the first blocking portion 210 blocks one end of the connecting hole 130, the slits 140a, 140b and the slit 150 of the body 100 and covers the contacts 300b, 300c. The second blocking portion 220 blocks the lead hole 160a, the housing holes 170a and the lead holes 180a and covers the contacts 300a in the housing hole 170a. The second blocking portion 230 blocks the lead hole 160b, the housing hole 170b and the lead hole 180b and covers the contact 300a in the housing hole 170b. In this state, the connecting portions 330a of the contacts 300a protrude from between the body 100 and the second blocking portions 220, 230 of the cover 200 to the outside. The connecting portion 330b of the contact 300b protrudes from between the body 100 and the second blocking portion 220 of the cover 200 to the outside. The connecting portion 330c of the contact 300c protrudes from between the body 100 and the second blocking portion 230 of the cover 200 to the outside. At this time, the outer surface of the first blocking portion 210 is flush with the end surface of the sixth end 116 of the body 100, the one end surface in the X direction of the second blocking portion 220 is flush with the end surface of the third end 113 of the main body 110, and the other end surface in the X direction of the second blocking portion 230 is flush with the end surface of the fourth end 114 of the main body 110. Also, the gap S1 is formed between the other end surface in the X direction of the second blocking portion 220 and the inner wall on the other side in the X direction of the first recess 111a of the main body 110. The gap S2 is formed between the one end surface in the X direction of the second blocking portion 230 and the inner wall on the one side in the X direction of the first recess 111b of the main body 110. The gap S3 is formed between the basal ends of the second blocking portions 220, 230 and the inner wall on the other side in the Y direction of the recess 111c of the main body 110.

The body 100, the contacts 300a to 300c and the cover 200 may be thus combined and then placed in a mold (not shown), and the insulating resin is poured into the mold for outsert molding. The insulating resin is outsert-molded into the molded portion 400. Then, the first molded portion 410 of the molded portion 400 covers the first blocking portion 210 of the cover 200 and the sixth end 116 of the body 100 and bonds the first blocking portion 210 to the sixth end 116 of the body 100. The second molded portions 421, 422 are filled into the first recesses 111a, 111b and the recess 111c of the main body 110, cover the second blocking portions 220, 230, and bond the second blocking portions 220, 230 to the first end 111 of the body 100. The third molded portions 431, 432 are filled into the second recesses 112a, 112b of the main body 110. The fourth molded portion 440 covers the third end 113 of the body 100 and the one side in the X direction of the second blocking portion 220, bonds the one end surface in the X direction of the second blocking portion 220 to the end surface of the third end 113 of the body 100. The fifth molded portion 450 covers the fourth end 114 of the body 100 and the other side in the X direction of the second blocking portion 230, and bonds the other end surface in the X direction of the second blocking portion 230 to the end surface of the fourth end 114 of the body 100. The connecting portions 330a, 330b, 330c of the contacts 300a, 300b, 300c pass through the fourth and fifth molded portions 440, 450, so that the distal ends 332a, 332b, 332c of the connecting portions 330a, 330b, 330c are placed outside of the fourth and fifth molded portions 440, 450.

The connector may be thus assembled and mounted on a circuit board of the electronic device in the following steps. First, the connector is placed on the circuit board. At this time, the distal ends 332a of the connecting portions 330a of the contacts 300a are each brought into contact with an electrode on the circuit board. The distal end 332b of the connecting portion 330b of the contact 300b is brought into contact with another electrode on the circuit board. The distal end 332c of the connecting portion 330c of the contact 300c is brought into contact with an earth electrode on the circuit board. After that, the distal ends 332a of the connecting portions 330a of the contacts 300a are soldered to the electrodes on the circuit board. The distal end 332b of the connecting portion 330b of the contact 300b is soldered to the another electrode on the circuit board. The distal end 332c of the connecting portion 330c of the contact 300c is soldered to the earth electrode on the circuit board.

The connector may be connected to a plug in the following steps. First, the plug is inserted into the connecting hole 130 of the connector. Then, the third electrode of the plug is elastically held between the contact portions 320b of the contact 300b. The second electrode of the plug elastically contacts the contact portion 320a of one of the three contacts 300a. The first electrode of the plug is held between the contact portions 320a of the remaining two contacts 300a. The earth electrode of the plug elastically contacts the contact portion 320c of the contact 300c.

The above-described connector has many advantageous features. First, the first molded portion 410 covers and blocks the boundary between the sixth end 116 of the main body 110 and the first blocking portion 210 of the cover 200. The second molded portions 421, 422 cover and block the boundaries between the second blocking portions 220, 230 and the first end 111 of the main body 110. The fourth molded portion 440 covers and blocks the boundary between the second blocking portion 220 and the third end 113 of the main body 110, the boundaries between the connecting portions 330a of the contacts 300a and the second blocking portion 220, the boundaries between the connecting portions 330a of the contacts 300a and the third end 113 of the main body 110, the boundary between the connecting portion 330b of the contact 300b and the second blocking portion 220, and the boundary between the connecting portion 330b of the contact 300b and the third end 113 of the main body 110. The fifth molded portion 450 covers and blocks the boundary between the second blocking portion 230 and the fourth end 114 of the main body 110, the boundary between the connecting portion 330a of the one contact 300a on the other side in the X direction and the second blocking portion 230, the boundary between the connecting portion 330a of the one contact 300a and the fourth end 114 of the main body 110, the boundary between the connecting portion 330c of the contact 300c and the second blocking portion 230, and the boundary between the connecting portion 330c of the contact 300c and the fourth end 114 of the main body 110. The connector is thus capable of preventing water intrusion from between the cover 200 and the body 100, between the body 100 and the connecting portions 330a, 330b, 330c of the contacts 300a, 300b, 300c, and between the cover 200 and the connecting portion 330a, 330b, 330c of the contacts 300a, 300b, 300c. Moreover, the connector can provide such waterproof property at low costs because the first molded portion 410, the second molded portions 421, 422, and the fourth and fifth molded portions 440, 450 are manufactured by outsert molding or in a similar method.

Further advantageously, the second molded portions 421, 422 are filled in the first recesses 111a, 111b and the recess 111c of the main body 110 to cover the second blocking portions 220, 230, and the third molded portions 431, 432 are filled in the second recesses 112a, 112b of the main body 110. Similarly, the fourth molded portion 440 covers the third end 113 of the body 100 and the one side in the X direction of the second blocking portion 220, and the fifth molded portion 450 covers the fourth end 114 of the body 100 and the other side in the X direction of the second blocking portion 230. In other words, the second molded portions 421, 422 and the third molded portions 431, 432 as provided such as to hold the body 100 and the cover 200 therebetween in the Z direction and the fourth and fifth molded portions 440, 450 hold the body 100 and the cover 200 therebetween in the X direction. As a result, the molded portion 400 provides an advantageously high bonding strength with respect to the cover 200 and the body 100.

### Embodiment 2

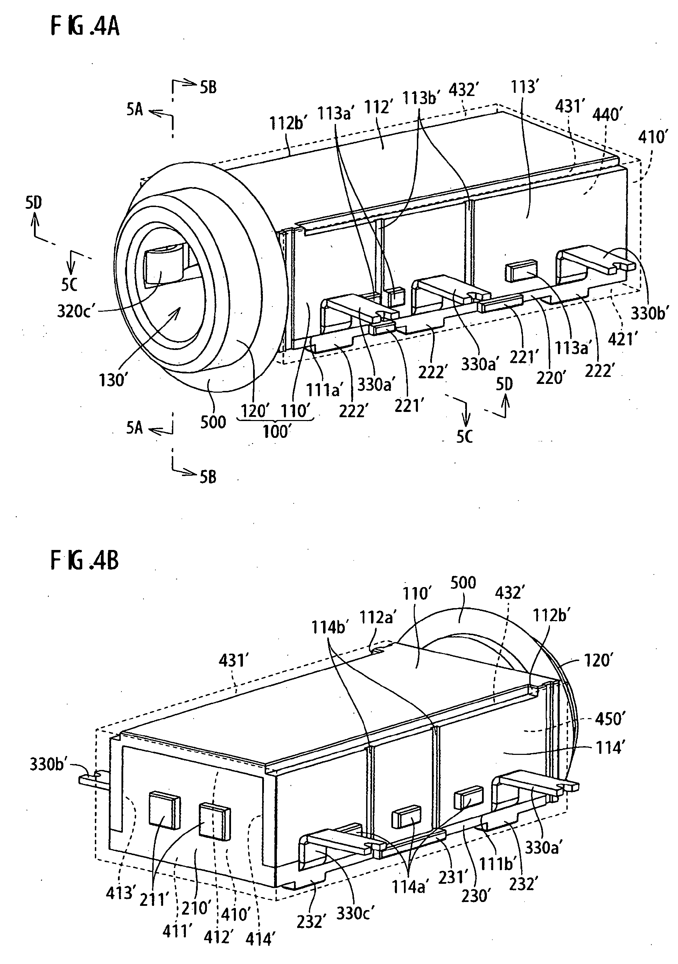

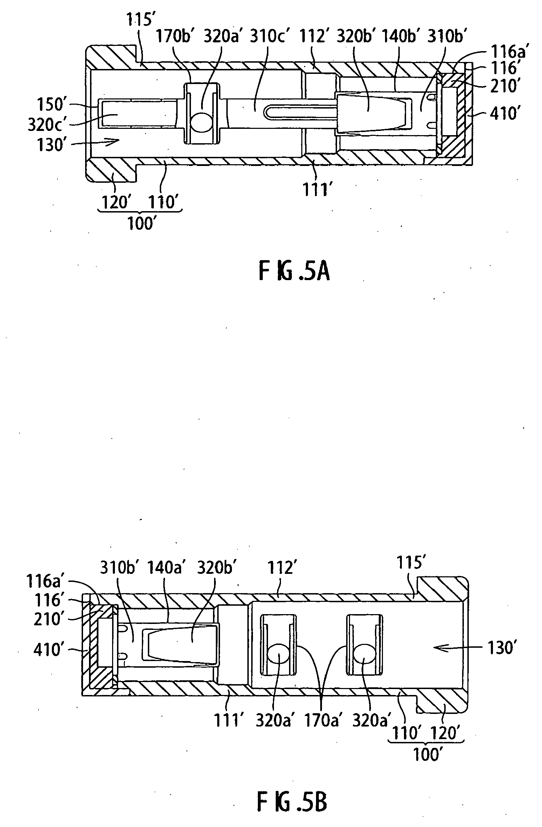

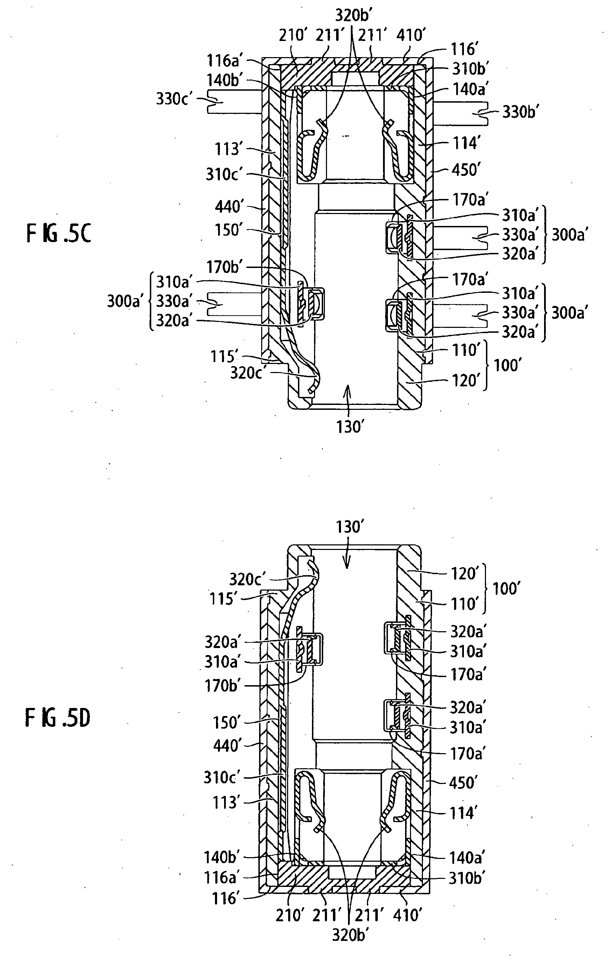

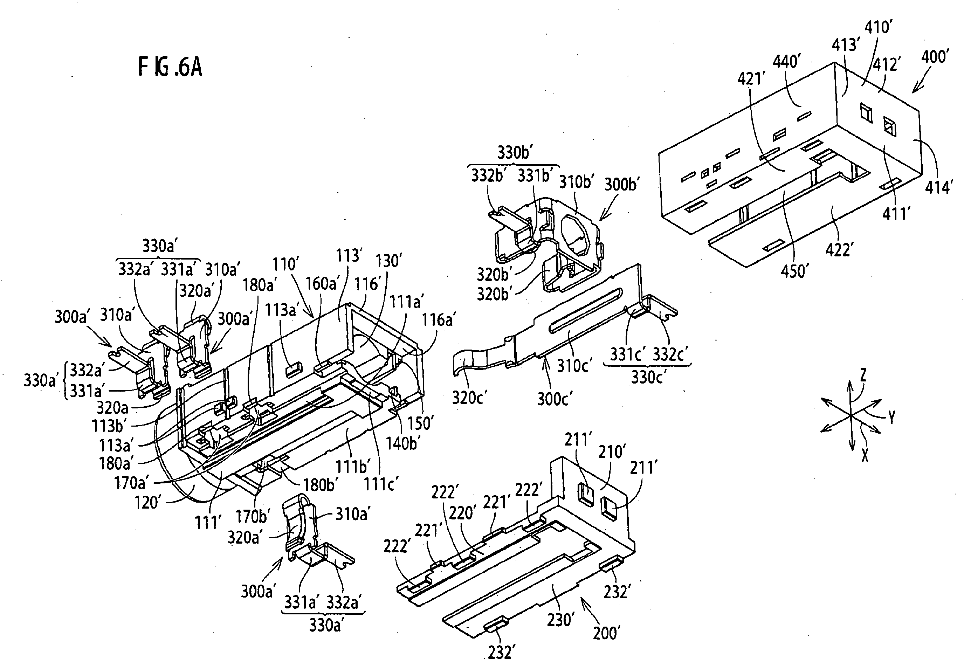

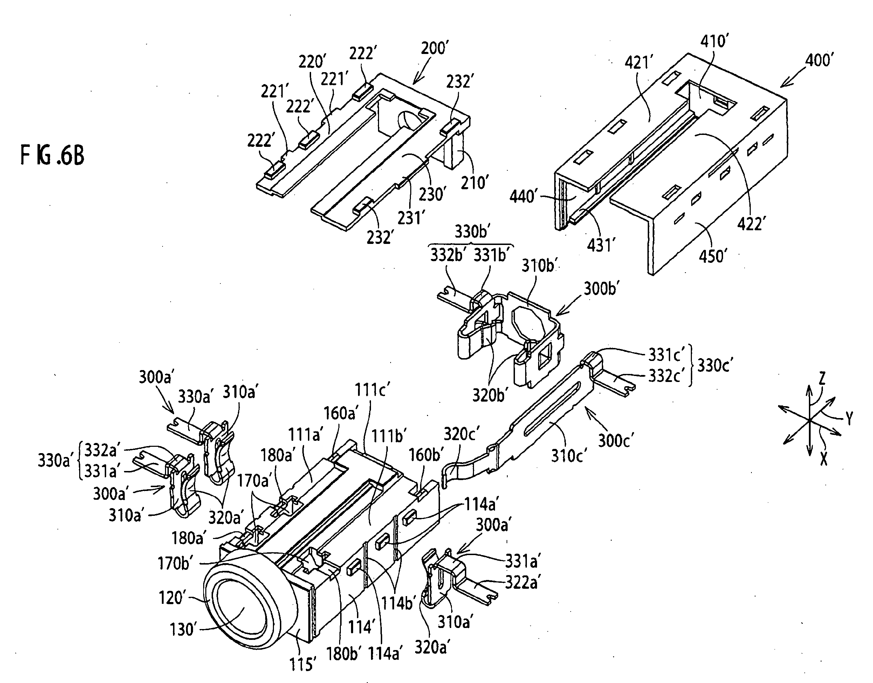

Next, a connector in accordance with Embodiment 2 of the invention will be described with reference to Fig. 4A to Fig. 6B. The connector shown in Fig. 4A to Fig. 6B is different from the connector in Embodiment 1 in that it is a mid-mount type connector to fit in a recess or a hole in a circuit board and be connected to the circuit board in this state. Specifically, to conform to the mid-mount type, the connector is different from the connector in Embodiment 1 in shape of a main body 110' of a body 100', a cover 200', connecting portions 330a' to 330c' of contacts 300a' to 300c' and a molded portion 400'. Only these differences from Embodiment 1 will be described below in detail, and the overlaps will be omitted. As described above, a symbol _'_ is added to reference numerals referring to the body, the cover, the contacts and the molded portion of this connector to distinguish them from the body, the cover, the contacts and the molded portion of the connector of Embodiment 1.

The body 100' has substantially the same configuration as the body 100 except for the following two points. The first difference is that an end surface of a third end 113' of the main body 110' is provided with a plurality of protrusions 113a' and grooves 113b', and an end surface of the fourth end 114' is provided with a plurality of protrusions 114a' and grooves 114b'. The protrusions 113a', 114a' are arranged in the Y direction with spacing therebetween. The grooves 113b', 114b' extend in the Z direction. The second difference is that first recesses 111a', 111b' of a first end 111' each has a region on the one end side in the Y direction that is narrower than the other region. Fig. 4A to Fig. 6B also illustrate a second end 112' of the main body, second recesses 112a', 112b' of the second end, a fifth end 115' of the main body, a sixth end 116' of the main body, a housing recess 116a', a ring 120', a connecting hole 130', slits 140a', 140b', 150', lead holes 160a', 160b', housing holes 170a', 170b', and lead holes 180a', 180b'.

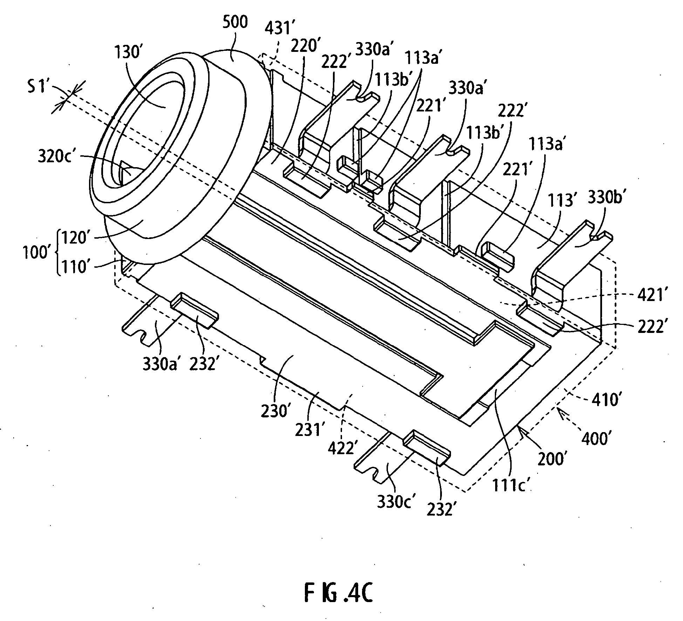

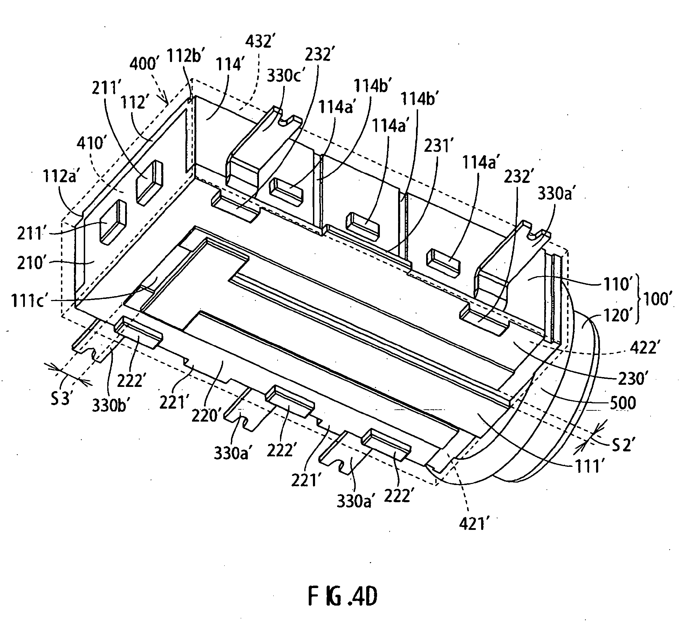

The cover 200' has substantially the same configuration as the cover 200 except for the following differences. Particularly, a first blocking portion 210' is provided with a plurality of protrusions 211', a second blocking portion 220' is provided with a plurality of protrusions 221', 222', and a second blocking portion 230' is provided with a plurality of protrusions 231', 232'. As shown in Fig. 4C, a gap S1' is provided between the other end face in the X direction of the second blocking portion 220' and the inner wall on the other side in the X direction of the first recess 111a' of the main body 110'. As shown in Fig. 4D, a gap S2' is provided between the one end surface in the X direction of the second blocking portion 230' and the inner wall on the one side in the X direction of the first recess 111b' of the main body 110'. As shown in Fig. 1D, a gap S3' is provided between the integrated basal end of the second blocking portions 220', 230' and the inner wall on other side in the Y direction of the recess 111c' of the main body 110'.

The contacts 300a' are different from the contacts 300a in that the connecting portions 330a' are bent upward in the generally L-shape. The connecting portions 330a' each include a basal end 331a' and a distal end 332a'. The basal end 331a' is continuous with the other end in the Z direction of a fixed portion 310a' and is bent toward one end in the Z direction. The basal end 331 a' passes through the lead holes 180a', 180b' of the main body 110' and protrudes toward the third ends 113', 114' of the main body 110'. The distal end 332a' is continuous with the basal end 331a' and is bent substantially perpendicularly to the basal end 331a'. The distal end 332a' passes through fourth and fifth molded portions 440', 450' of the molded portion 400'. Fig. 4A to Fig. 6B also illustrate contact portions 320a'.

The contact 300b' is different from the contact 300b in that a connecting portion 330b' is bent upward in generally L-shape. The connecting portion 330b' includes a basal end 331b' and a distal end 332b'. The basal end 331b' is continuous with the other end in the Z direction of the fixed portion 310b' and is folded toward the one end in the Z direction. The basal end 331b' passes through the lead hole 160a' of the main body 110' and protrudes toward the third end 113' of the main body 110'. The distal end 332b' is continuous with the basal end 331b' and bent substantially perpendicularly to the basal end 331b'. The distal end 332b' passes through the fourth molded portion 440' of the molded portion 400'. Fig. 4A to Fig. 6B also illustrate contact portions 320b'.

The contact 300c' is different from the contact 300c in that a connecting portion 330c' is bent upward in generally L-shape. The connecting portion 330c' includes a basal end 331 c' and a distal end 332c'. The basal end 331 c' is continuous with the other end in the Z direction of the fixed portion 310c' and is folded toward the one end in the Z direction. The basal end 331 c' passes through the lead hole 160b' of the main body 110' and protrudes toward the fourth end 114' of the main body 110'. The distal end 332c' is continuous with the basal end 331 c' and is bent substantially perpendicularly to the basal end 331c'. The distal end 332c' passes through the fifth molded portion 450' of the molded portion 400'. Fig. 4A to Fig. 6B also illustrate a contact portion 320c'.

The molded portion 400' has substantially the same configuration as the molded portion 400 except for the following two points. The first difference is that the protrusions 211' are embedded in the first molded portion 410', the protrusions 222', 232' are embedded in the second molded portions 421', 422', the protrusions 221' are embedded in the fourth molded portion 440', and the protrusion 231' is embedded in the fifth molded portion 450'. The second difference is that the fourth molded portion 440' is filled in the grooves 113b', and the fifth molded portion 450' is filled in the grooves 113b'. Fig. 4A to Fig. 6B also illustrate third molded portions 431', 432'.

The connector with the above-mentioned configuration may be assembled in a similar manner as in Embodiment 1. The assembled connector may be mounted on a circuit board of an electronic device in the following steps. First, the connector is placed in a recess or a hole of the circuit board. Then, the distal ends 332a' of the connecting portions 330a' of the contacts 300a' each contact an electrode on an edge of the recess or hole of the circuit board. The distal end 332b' of the connecting portion 330b' of the contact 300b' contacts another electrode on the edge of the recess or hole of the circuit board. The distal end 332c' of the connecting portion 330c' of the contact 300c' contacts an earth electrode on the edge of the recess or hole of the circuit board. After that, the distal ends 332a' of the connecting portions 330a' of the contacts 300a' are soldered to the electrodes on the circuit board. The distal end 332b' of the connecting portion 330b' of the contact 300b' is soldered to said another electrode on the circuit board. The distal end 332c' of the connecting portion 330c' of the contact 300c' is soldered to the earth electrode on the circuit board.

The connector may be connected to a plug in the following steps. First, the plug is inserted into the connecting hole 130' of the connector. Then, the third electrode of the plug is elastically held between the contact portions 320b' of the contact 300b'. The second electrode of the plug elastically contacts the contact portion 320a' of one of the three contacts 300a'. The first electrode of the plug is elastically held between the contact portion 320a' of the remaining two contacts 300a'. The earth electrode of the plug elastically contacts the contact portions 320c' of the contact 300c'.

The above-described connector has many advantageous features. First, the first molded portion 410' covers and blocks the boundary between the sixth end 116' of the main body 110' and the first blocking portion 210' of the cover 200'. The second molded portions 421', 422' cover and block the boundaries between the second blocking portions 220', 230' and the first end 111' of the main body 110'. The fourth molded portion 440' covers and blocks the boundary between the second blocking portion 220' and the third end 113' of the main body 110', the boundaries between the connecting portions 330a' of the contacts 300a' and the second blocking portion 220', the boundaries between the connecting portions 330a' of the contacts 300a' and the third end 113' of the main body 110', the boundary between the connecting portion 330b' of the contact 300b' and the second blocking portion 220', and the boundary between the connecting portion 330b' of the contact 300b' and the third end 113' of the main body 110'. The fifth molded portion 450' covers and blocks the boundary between the second blocking portion 230' and the fourth end 114' of the main body 110', the boundary between the connecting portion 330a' of the contact 300a' and the second blocking portion 230', the boundary between the connecting portion 330a' of the contact 300a' and the fourth end 114' of the main body 110', the boundary between the connecting portion 330c' of the contact 300c' and the second blocking portion 230', and the boundary between the connecting portion 330c' of the contact 300c' and the fourth end 114' of the main body 110'. The connector is thus capable of preventing water intrusion from between the cover 200' and the body 100', between the body 100' and the connecting portions 330a', 330b', 330c' of the contacts 300a', 300b', 300c', and between the cover 200' and the connecting portion 330a', 330b', 330c' of the contacts 300a', 300b', 300c'. Moreover, the connector can provide such waterproof property at low costs because the first molded portion 410', the second molded portions 421', 422', and the fourth and fifth molded portions 440', 450' are manufactured by outsert molding or in a similar method.

Further advantageously, the second molded portions 421', 422' are filled in the first recesses 111a', 111b' and the recess 111c' of the main body 110' to cover the second blocking portions 220', 230', and the third molded portions 431', 432' are filled in the second recesses 112a', 112b' of the main body 110'. Similarly, the fourth molded portion 440' covers the third end 113' of the body 100' and the one side in the X direction of the second blocking portion 220', and the fifth molded portion 450' covers the fourth end 114' of the body 100' and the other side in the X direction of the second blocking portion 230'. In other words, the second molded portions 421', 422' and the third molded portions 431', 432' hold the body 100' and the cover 200' therebetween in the Z direction, and the fourth and fifth molded portions 440', 450' hold the body 100' and the cover 200' in the X direction. As a result, the molded portion 400' provides an advantageously high bonding strength with respect to the cover 200' and the body 100'.

Still further advantageously, the protrusions 211' of the first blocking portion 210' are embedded in the first molded portion 410', the protrusions 222', 232' of the second blocking portion 220', 230' are embedded in the second molded portion 421', 422', the protrusions 221' of the second blocking portion 220' are embedded in the fourth molded portion 440', and the protrusion 231' of the second blocking portion 230' is embedded in the fifth molded portion 450'. The fourth and fifth molded portions 440', 450' are filled in the grooves 113b', 114b' of the main body 110'. These features of the molded portion 400' also contribute to an advantageously high bonding strength with respect to the cover 200' and the body 100'.

The connectors of the invention are not limited to ones in accordance with the above-mentioned embodiments. They may be modified in design in any manner within the scope of the claims. Specific modifications will be described in detail below.

The body may include the connecting hole, the plurality of housing holes, the plurality of slits, and the housing recess as in Embodiments 1 and 2. However, the body may be modified in any manner as long as the body includes a connecting hole, and a housing hole or slit that communicates with the connecting hole and is open to the outside of the body. For example, the slit may be provided in the bottom of the first recess of the first end of the body. Alternatively, the body may be provided with housing holes on one side or both sides in the X direction of the connecting hole of the body.

The connecting hole may pass through the main body and the ring in the Y direction as in Embodiments 1 and 2. The connecting hole may be of any shape if provided in the body and adapted to detachably receive a mating connector.

The main body may be provided with the lead holes communicating with the housing hole and the slit as in Embodiments 1 and 2. The lead holes may be omitted. If omitted, the connecting portions of the contacts may protrude from a gap or gaps between the body and the cover to the outside of the body and the cover. Alternatively, there may be at least one lead hole provided in at least one of the body and the cover to connect the housing hole or slit to the outside of the body and the cover. Specifically, the cover may have at least one lead hole, or the cover and the body may each have at least one lead hole.

The first end of the body may be provided with the two first recesses as in Embodiments 1 and 2. The first recesses may be omitted. Particularly, the first end of the body may have housing holes or slits in place of the first recesses. Alternatively, the first end of the body may be provided with one first recess or three or more first recesses.

The second end of the body may be provided with the two second recesses as in Embodiments 1 and 2. The second recesses may be omitted. Particularly, the second end of the body may have housing holes or slits in place of the first recesses. Alternatively, the second end of the body may be provided with one second recess or three or more second recesses.

The cover may include the first blocking portion and the two second blocking portions as in Embodiments 1 and 2. Alternatively, the cover may be modified as long as it can block the housing hole or slit of the body. For example, the cover may have only the first blocking portion if the bodies 100, 100' are provided with the connecting holes 130, 130' and the slits 140a, 140b, 140a', 140b' only the cover may have only the second blocking portions if the bodies 100, 100' are provided with the connecting holes 130, 130' and the housing holes 170a, 170a' only. Alternatively, the cover may be provided with a single second blocking portion to cover the lead holes 160a, 160b, the housing holes 170a, 170b and the lead holes 180a, 180b of the first end 111 of the body 100, or to cover the lead hole 160a', 160b', the housing holes 170a', 170b' and the lead holes 180a', 180b' of the first end 111' of the body 100'.

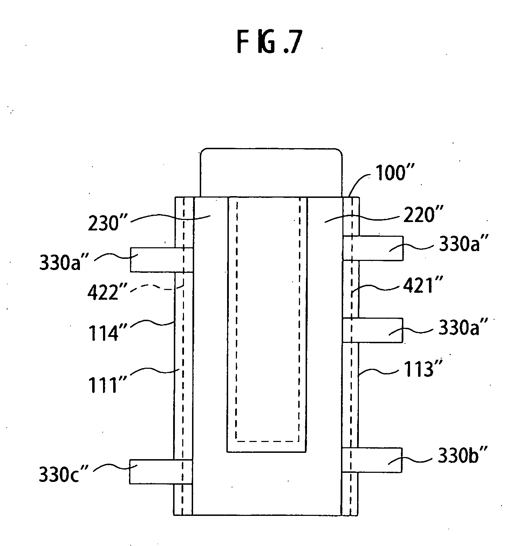

The invention is not limited to the arrangement of Embodiments I and 2 where the one end surface in the X direction of the second blocking portion is flush with the end surface of the third end of the main body, and where the other end surface in the X direction of the second blocking portion is flush with the end surface of the fourth end of the main body. For example, the cover and the molded portion may be modified as shown in Fig. 7. More particularly, the end surface on the one side in the X direction of the second blocking portion 220" is located closer to the other side in the X direction than the end surface of a third end 113" of the body 100", and the end surface on the other side in the X direction of the second blocking portion 230" is located closer to the one side in the X direction than the end surface of a fourth end 114" of the body 100".

In this case, the following boundaries are all on the same plane of a first end 111" of the body 100"-namely, the boundaries between end surfaces on one and the other sides in the X direction of the second blocking portions 220", 230" and the body 100", the boundaries between the second blocking portion 220" and connecting portions 330a", 330b" of contacts, the boundaries between the body 100" and the connecting portions 330a", 330b" of the contacts, the boundaries between the second blocking portion 230" and the connecting portions 330a", 330c" of the contacts, and the boundaries between the body 100" and the connecting portions 330a", 330c" of the contacts. A second molded portion 421" covers the second blocking portion 220" and bonds the second blocking portion 220" to the first end 111" of the body 100". The connecting portions 330a", 330b" pass through the second molded portion 421 ". In other words, the second molded portion 421" covers and blocks the boundary between the end surface on the one side in the X direction of the second blocking portion 220" and the first end 111" of the body 100", the boundary between the end surface on the other side in the X direction of the second blocking portion 220" and the first end 111" of the body 100", the boundaries between the second blocking portion 220" and the connecting portions 330a", 330b" of the contacts, and the boundaries between the first end 111" of the body 100" and the connecting portions 330a", 330b" of the contacts. Another second molded portion 422" covers the second blocking portion 230" and bonds the second blocking portion 230" to the first end 111" of the body 100". The connecting portions 330a", 330c" pass through the second molded portion 422". In other words, the second molded portion 422" covers and blocks the boundary between the end surface on the one side in the X direction of the second blocking portion 230" and the first end 111" of the body 100", the boundary between the end surface on the other side in the X direction of the second blocking portion 230" and the first end 111" of the body 100", the boundaries between the second blocking portion 230" and the connecting portions 330a", 330c" of the contacts, and the boundaries between the first end 111" of the body 100" and the connecting portions 330a", 330c" of the contacts. In this case, the fourth and fifth molded portions may be omitted.

The main body and the cover may be modified such that only the one end surface in the X direction of the second blocking portion and the end surface of the third end of the main body are flush with each other. Alternative modification is that only the other end surface in the X direction of the second blocking portion and the end surface of the fourth end of the main body are flush with each other.

The molded portion may include the first molded portion, the two second molded portions, the two third molded portions, the fourth molded portion and the fifth molded portion as in Embodiments 1 and 2. The molded portion may be modified in any manner as long as it is an element of insulating resin adapted to cover at least a boundary between the body and the cover, a boundary between the body and the connecting portion of the contact, and a boundary between the cover and the connecting portion of the contact. For example, the molded portion may include a first molded portion having a first end in the Z direction and a second end in the Z direction on the opposite side from the first end, a second molded portion communicating with the first end of the first molded portion, and a third molded portion communicating with the second end of the first molded portion. In this case, the first molded portion may cover the first blocking portion blocking one side of the connecting hole passing through the body and bond the first blocking portion to the body. The second molded portion may be filled in the first recess of the first end of the body, cover the second blocking portion blocking the housing hole or slit in the bottom of the first recess, and bond the second blocking portion to the body. The third molded portion may be filled in the second recess of the body. In the case where the first end of the body is provided with the housing holes or the like in place of the first and second recesses, the second and third molded portions may be modified to cover the first and second ends, respectively, of the body.

The outer surface of the body may be provided with the protrusions and the grooves and the outer surface of the cover may be provided with the protrusions as in Embodiment 2. The invention is not limited to this configuration, and the protrusions and the grooves may be omitted as in Embodiment 1. The protrusions and/or the grooves may be provided only in the outer surface of the body, or alternatively only in the outer surface of the cover. The protrusions may be modified in any manner as long as the protrusions are embedded in the molded portion. The grooves may be modified in any manner as long as the molded portion is filled in the grooves.

The above-mentioned embodiments and modification examples are described by way of examples only. The materials, shapes, sizes, numbers and arrangements of the elements of the connectors of the invention may be modified as long as they are included in the scope as defined by the appended claims.

### Reference Signs List

- 100: body
110 main body
111 first end
111a first recess
111b first recess
112 second end
112a second recess
112b second recess
113 third end
114 fourth end
115 fifth end
116 sixth end
120 ring
130 connecting hole
140a slit
140b slit
150 slit
160a lead hole
160b lead hole
170a housing hole
170b housing hole
180a lead hole
180b lead hole
- 200: cover
210 first blocking portion
220 second blocking portion
230 second blocking portion
- 300a: contact
310a fixed portion
320a contact portion
330a connecting portion
331 a basal end
332a distal end
- 300b: contact
310b fixed portion
320b contact portion
330b connecting portion
331b basal end
332b distal end
- 300c: contact
310c fixed portion
320c contact portion
330c connecting portion
331c basal end
332c distal end
- 400: molded portion
410 first molded portion
421 second molded portion
422 second molded portion
431 third molded portion
432 third molded portion
440 fourth molded portion
450 fifth molded portion
- 500: gasket

## Claims

1. A waterproof connector comprising:
a body (100; 100') including:
a connecting hole (130; 130'), and
a housing hole (170a, 170b; 170a', 170b') or slit (140a, 140b, 150; 140a', 140b', 150') communicating with the connecting hole and being open to an outside of the body;
a cover (200; 200') to block the housing hole or slit of the body;
a contact (300a, 300b, 300c; 300a', 300b', 300c') including:
a fixed portion (310a, 310b, 310c; 310a', 310b', 310c') fixedly attached in the housing hole or slit of the body,
a contact portion (320a, 320b, 320c; 320a', 320b', 320c') disposed in the connecting hole, and
a connecting portion (330a, 330b, 330c; 330a', 330b', 330c') protruding from between the body and the cover to an outside of the body and the cover; and
a molded portion (400; 400') of insulating resin to cover and block at least boundaries between:
the body and the cover,
the body and the connecting portion of the contact, and
the cover and the connecting portion of the contact.

2. The waterproof connector according to claim 1, wherein
the connecting hole (130; 130') passes through the body (100; 100') in a first direction, the body further includes:
a first end (111; 111') in a second direction orthogonal to the first direction,
a second end (112; 112') in the second direction on the opposite side from the first end,
a first recess (111a, 111b; 111a', 111b') provided in the first end, the first recess having a bottom provided with the housing hole (170a, 170b; 170a', 170b') or slit (140a, 140b, 150; 140a', 140b', 150'), and
a second recess (112a, 112b; 112a', 112b') provided in the second end,
the cover (200; 200') includes:
a first blocking portion (210; 210') to block the connecting hole, and
a second blocking portion (220; 220') housed in the first recess so as to block the housing hole or slit, and
the molded portion (400; 400') includes:
a first molded portion (410; 410') covering the first blocking portion and bonding the first blocking portion to the body, the first molded portion including a first end (411; 411') in the second direction and a second end (412; 412') in the second direction on the opposite side from the first end,
a second molded portion (421, 422; 421', 422') being continuous with the first end of the first molded portion and filled in the first recess of the body, the second molded portion covering the second blocking portion and bonding the second blocking portion to the body, and
a third molded portion (431, 432; 431', 432') being continuous with the second end of the first molded portion and filled in the second recess of the body.

3. The waterproof connector according to claim 2, wherein
the body (100; 100') further includes:
a third end (113; 113') in a third direction orthogonal to the first and second directions, and
a fourth end (114; 114') in the third direction on the opposite side from the third end,
the first molded portion (410; 410') further includes:
a third end (413; 413') in the third direction, and
a fourth end (414; 414') in the third direction on the opposite side from the third end, and
the molded portion (400; 400') further includes:
a fourth molded portion (440; 440') continuous with the third end of the first molded portion, the fourth molded portion covering the third end of the body, and
a fifth molded portion (450; 450') continuous with the fourth end of the first molded portion, and the fifth molded portion covering the fourth end of the body.

4. The waterproof connector according to claim 3, wherein
one end surface in the third direction of the second blocking portion (220; 220') is flush with an end surface of the third end (113; 113') of the body (100; 100'), and
the fourth molded portion (440; 440') bonds the end surface of the second blocking portion to the end surface of the third end of the body.

5. The waterproof connector according to claim 3, wherein
the other end surface in the third direction of the second blocking portion (230; 230') is flush with an end surface of the fourth end (114; 114') of the body (100; 100'), and
the fifth molded portion (450; 450') bonds the end surface of the second blocking portion to the end surface of the fourth end of the body.

6. The waterproof connector according to claim 2, wherein
the connecting portion (330a, 330b, 330c; 330a', 330b', 330c') of the contact (300a, 300b, 300c; 300a', 300b', 300c') passes through the second molded portion (421, 422; 421', 422').

7. The waterproof connector according to any one of claims 3 to 5, wherein
the connecting portion (330a, 330b, 330c; 330a', 330b', 330c') of the contact (300a, 300b, 300c; 300a', 300b', 300c') passes through the fourth (440; 440') or fifth (450; 450') molded portion.

8. The waterproof connector according to any one of claims 1 to 7, wherein
at least one of the body (100; 100') and the cover (200; 200') is provided with a lead hole (160a, 160b, 180a, 180b; 160a', 160b', 180a', 180b') for interconnecting between the housing hole (170a, 170b; 170a', 170b') or slit (140a, 140b, 150; 140a', 140b', 150') and the outside of the body and the cover, and
the connecting portion (330a, 330b, 330c; 330a', 330b', 330c') of the contact (300a, 300b, 300c; 300a', 300b', 300c') protrudes through the lead hole to the outside of the body and the cover.

9. The waterproof connector according to any one of claims 1 to 8, wherein
at least one of the body (100; 100'), the cover (200; 200') and the molded portion (400; 400') is made of a polyamide resin.

10. The waterproof connector according to any one of claims 1 to 9, further comprising a ring-shaped gasket (500) to fit around the body (100; 100').

11. An electronic device comprising the waterproof connector according to any one of claims 1 to 10.

## Patentansprüche

1. Wasserdichte Verbindungseinrichtung, umfassend:
einen Körper (100; 100'), der enthält:
ein Verbindungsloch (130; 130') und
ein Gehäuseloch (170a, 170b; 170a', 170b') oder einen Schlitz (140a, 140b, 150; 140a', 140b', 150'), das bzw. der mit dem Verbindungsloch kommuniziert und zum Äußeren des Körpers hin offen ist;
eine Abdeckung (200; 200') zum Blockieren des Gehäuselochs oder des Schlitzes des Körpers;
einen Kontakt (300a, 300b, 300c; 300a', 300b', 300c'), der enthält:
einen festen Abschnitt (310a, 310b, 310c; 310a', 310b', 310c'), der fest in dem Gehäuseloch oder Schlitz des Körpers angebracht ist,
einen Kontaktabschnitt (320a, 320b, 320c; 320a', 320b', 320c'), der im Verbindungsloch angeordnet ist, und
einen Verbindungsabschnitt (330a, 330b, 330c; 330a', 330b', 330c'), der von zwischen dem Körper und der Abdeckung aus zum Äußeren des Körpers und der Abdeckung hin hervorragt; und
einen geformten Abschnitt (400; 400') aus Isolierharz zum Abdecken und Blockieren zumindest von Grenzen zwischen:
dem Körper und der Abdeckung,
dem Körper und dem Verbindungsabschnitt des Kontakts und
der Abdeckung und dem Verbindungsabschnitt des Kontakts.

2. Wasserdichte Verbindungseinrichtung nach Anspruch 1, wobei
das Verbindungsloch (130; 130') den Körper (100; 100') in einer ersten Richtung durchquert,
der Körper ferner enthält:
ein erstes Ende (111; 111') in einer zur ersten Richtung senkrechten zweiten Richtung,
ein zweites Ende (112; 112') in der zweiten Richtung auf der gegenüberliegenden Seite vom ersten Ende,
eine erste Aussparung (111a, 111b; 111a', 111b'), die im ersten Ende vorgesehen ist, wobei die erste Aussparung einen Boden aufweist, der mit dem Gehäuseloch (170a, 170b; 170a', 170b') oder dem Schlitz (140a, 140b, 150; 140a', 140b', 150') versehen ist, und
eine zweite Aussparung (112a, 112b; 112a', 112b'), die im zweiten Ende vorgesehen ist,
wobei die Abdeckung (200; 200') enthält:
einen ersten Blockierabschnitt (210; 210') zum Blockieren des Verbindungslochs, und
einen zweiten Blockierabschnitt (220; 220'), der in der ersten Aussparung aufgenommen ist, um so das Gehäuseloch oder den Schlitz zu blockieren, und
wobei der geformte Abschnitt (400; 400') enthält:
einen ersten geformten Abschnitt (410; 410'), der den ersten Blockierabschnitt abdeckt und den ersten Blockierabschnitt mit dem Körper verbindet, wobei der erste geformte Abschnitt ein erstes Ende (411; 411') in der zweiten Richtung und ein zweites Ende (412; 412') in der zweiten Richtung auf der dem ersten Ende gegenüberliegenden Seite enthält,
einen zweiten geformten Abschnitt (421, 422; 421', 422'), der durchgängig mit dem ersten Ende des ersten geformten Abschnitts vorgesehen ist und in die erste Aussparung des Körpers eingefüllt ist, wobei der zweite geformte Abschnitt den zweiten Blockierabschnitt abdeckt und den zweiten Blockierabschnitt mit dem Körper verbindet, und
einen dritten geformten Abschnitt (431, 432; 431', 432'), der durchgängig mit dem zweiten Ende des ersten geformten Abschnitts vorgesehen ist und in die zweite Aussparung des Körpers eingefüllt ist.

3. Wasserdichte Verbindungseinrichtung nach Anspruch 2, wobei
der Körper (100; 100') ferner enthält:
ein drittes Ende (113; 113') in einer zu der ersten und der zweiten Richtung senkrechten dritten Richtung und
ein viertes Ende (114; 114') in der dritten Richtung auf der dem dritten Ende gegenüberliegenden Seite,
der erste geformte Abschnitt (410; 410') ferner enthält:
ein drittes Ende (413; 413') in der dritten Richtung und
ein viertes Ende (414; 414') in der dritten Richtung auf der dem dritten Ende gegenüberliegenden Seite und
der geformte Abschnitt (400; 400') ferner enthält:
einen vierten geformten Abschnitt (440; 440'), der durchgängig mit dem dritten Ende des ersten geformten Abschnitts vorgesehen ist, wobei der vierte geformte Abschnitt das dritte Ende des Körpers abdeckt, und
einen fünften geformten Abschnitt (450; 450'), der durchgängig mit dem vierten Ende des ersten geformten Abschnitts vorgesehen ist, wobei der fünfte geformte Abschnitt das vierte Ende des Körpers abdeckt.

4. Wasserdichte Verbindungseinrichtung nach Anspruch 3, wobei
eine Endfläche in der dritten Richtung des zweiten Blockierabschnitts (220; 220') bündig mit einer Endfläche des dritten Endes (113; 113') des Körpers (100; 100') vorgesehen ist, und
der vierte geformte Abschnitt (440; 440') die Endfläche des zweiten Blockierabschnitts mit der Endfläche des dritten Endes des Körpers verbindet.

5. Wasserdichte Verbindungseinrichtung nach Anspruch 3, wobei
die andere Endfläche in der dritten Richtung des zweiten Blockierabschnitts (230; 230') bündig mit einer Endfläche des vierten Endes (114; 114') des Körpers (100; 100') vorgesehen ist, und
der fünfte geformte Abschnitt (450; 450') die Endfläche des zweiten Blockierabschnitts mit der Endfläche des vierten Endes des Körpers verbindet.

6. Wasserdichte Verbindungseinrichtung nach Anspruch 2, wobei
der Verbindungsabschnitt (330a, 330b, 330c; 330a', 330b', 330c') des Kontakts (300a, 300b, 300c; 300a', 300b', 300c') den zweiten geformten Abschnitt (421, 422; 421', 422') durchquert.

7. Wasserdichte Verbindungseinrichtung nach einem der Ansprüche 3 bis 5, wobei
der Verbindungsabschnitt (330a, 330b, 330c; 330a', 330b', 330c') des Kontakts (300a, 300b, 300c; 300a', 300b', 300c') den vierten (440; 440') oder den fünften (450; 450') geformten Abschnitt durchquert.

8. Wasserdichte Verbindungseinrichtung nach einem der Ansprüche 1 bis 7, wobei
der Körper (100; 100') und/oder die Abdeckung (200; 200') mit einem Führungsloch (160a, 160b, 180a, 180b; 160a', 160b', 180a', 180b') zur Verbindung zwischen dem Gehäuseloch (170a, 170b; 170a', 170b') oder dem Schlitz (140a, 140b, 150; 140a', 140b', 150') und dem Äußeren des Körpers und der Abdeckung versehen sind und
der Verbindungsabschnitt (330a, 330b, 330c; 330a', 330b', 330c') des Kontakts (300a, 300b, 300c; 300a', 300b', 300c') durch das Führungsloch zum Äußeren des Körpers und der Abdeckung hin hervorragt.

9. Wasserdichte Verbindungseinrichtung nach einem der Ansprüche 1 bis 8, wobei
der Körper (100; 100'), die Abdeckung (200; 200') und/oder der geformte Abschnitt (400; 400') aus Polyamidharz hergestellt sind.

10. Wasserdichte Verbindungseinrichtung nach einem der Ansprüche 1 bis 9, ferner umfassend eine ringförmige Dichtung (500) zum Umfassen des Körpers (100; 100').

11. Elektronisches Gerät, das die wasserdichte Verbindungseinrichtung nach einem der Ansprüche 1 bis 10 umfasst.

## Revendications

1. Connecteur étanche comprenant :
un corps (100 ; 100') comprenant :
un orifice de raccordement (130, 130'), et
un orifice (170a, 170b ; 170a', 170b') ou une fente (140a, 140b, 150 ; 140a', 140b', 150') de boîtier communiquant avec l'orifice de raccordement et étant ouvert(e) sur un extérieur du corps ;
un couvercle (200 ; 200') pour bloquer l'orifice ou fente de boîtier du corps ;
un contact (300a, 300b, 300c ; 300a', 300b', 300c') comprenant :
une partie fixe (310a, 310b, 310c ; 310a', 310b', 310c') fixée de manière fixe dans un orifice ou fente de boîtier du corps,
une partie de contact (320a, 320b, 320c ; 320a', 320b', 320c') disposée dans l'orifice de raccordement, et
une partie de raccordement (330a, 330b, 330c ; 330a', 330b', 330c') faisant saillie, à partir de l'endroit situé entre le corps et le couvercle jusqu'à un extérieur du corps et du couvercle ; et
une partie moulée (400 ; 400') de résine isolante pour recouvrir et bloquer au moins des limites entre :
le corps et le couvercle,
le corps et la partie de raccordement du contact, et
le couvercle et la partie de raccordement du contact.

2. Connecteur étanche selon la revendication 1, dans lequel :
l'orifice de raccordement (130 ; 130') passe à travers le corps (100 ; 100') dans une première direction, le corps comprend en outre :
une première extrémité (111 ; 111') dans une deuxième direction orthogonale à la première direction,
une deuxième extrémité (112 ; 112') dans la deuxième direction sur le côté opposé à la première extrémité,
un premier évidement (111a, 111b ; 111a', 111b') prévu dans la première extrémité, le premier évidement ayant un fond prévu avec l'orifice (170a, 170b ; 170a', 170b') ou la fente (140a, 140b, 150 ; 140a', 140b', 150') de boîtier, et
un second évidement (112a, 112b; 112a', 112b') prévu dans la deuxième extrémité, le couvercle (200 ; 200') comprend :
une première partie de blocage (210 ; 210') pour bloquer l'orifice de raccordement, et
une seconde partie de blocage (220 ; 220') logée dans le premier évidement afin de bloquer l'orifice ou fente de boîtier, et
la partie moulée (400 ; 400') comprend :
une première partie moulée (410 ; 410') recouvrant la première partie de blocage et reliant la première partie de blocage au corps, la première partie moulée comprenant une première extrémité (411 ; 411') dans la deuxième direction et une deuxième extrémité (412 ; 412') dans la deuxième direction sur le côté opposé à la première extrémité,
une deuxième partie moulée (421, 422 ; 421', 422') étant continue avec la première extrémité de la première partie moulée et remplie dans le premier évidement du corps, la deuxième partie moulée recouvrant la seconde partie de blocage et reliant la seconde partie de blocage au corps, et
une troisième partie moulée (431, 432; 431', 432) étant continue avec la deuxième extrémité de la première partie moulée et remplie dans le second évidement du corps.

3. Connecteur étanche selon la revendication 2, dans lequel :
le corps (100 ; 100') comprend en outre :
une troisième extrémité (113 ; 113') dans une troisième direction orthogonale aux première et deuxième directions, et
une quatrième extrémité (114 ; 114') dans la troisième direction sur le côté opposé à la troisième extrémité,
la première partie moulée (410 ; 410') comprend en outre :
une troisième extrémité (413 ; 413') dans la troisième direction, et
une quatrième extrémité (414 ; 414') dans la troisième direction du côté opposé à la troisième extrémité, et
la partie moulée (400 ; 400') comprend en outre :
une quatrième partie moulée (440 ; 440') continue avec la troisième extrémité de la première partie moulée, la quatrième partie moulée recouvrant la troisième extrémité du corps, et
une cinquième partie moulée (450 ; 450') continue avec la quatrième extrémité de la première partie moulée, et la cinquième partie moulée recouvrant la quatrième extrémité du corps.

4. Connecteur étanche selon la revendication 3, dans lequel :
une surface d'extrémité dans la troisième direction de la seconde partie de blocage (220 ; 220') est de niveau avec une surface d'extrémité de la troisième extrémité (113 ; 113') du corps (100 ; 100'), et
la quatrième partie moulée (440 ; 440') relie la surface d'extrémité de la seconde partie de blocage à la surface d'extrémité de la troisième extrémité du corps.

5. Connecteur étanche selon la revendication 3, dans lequel :
l'autre surface d'extrémité dans la troisième direction de la seconde partie de blocage (230 ; 230') est de niveau avec une surface d'extrémité de la quatrième extrémité (114 ; 114') du corps (100 ; 100'), et
la cinquième partie moulée (450 ; 450') relie la surface d'extrémité de la seconde partie de blocage à la surface d'extrémité de la quatrième extrémité du corps.

6. Connecteur étanche selon la revendication 2, dans lequel :
la partie de raccordement (330a, 330b, 330c ; 330a', 330b', 330c') du contact (300a, 330b, 300c ; 300a', 300b', 300c') passe à travers la deuxième partie moulée (421, 422 ; 421', 422').

7. Connecteur étanche selon l'une quelconque des revendications 3 à 5, dans lequel :
la partie de raccordement (330a, 330b, 330c ; 330a', 330b', 330c') du contact (300a, 300b, 300c ; 300a', 300b', 300c') passe à travers la quatrième (440 ; 440') ou cinquième (450 ; 450') partie moulée.

8. Connecteur étanche selon l'une quelconque des revendications 1 à 7, dans lequel :
au moins l'un parmi le corps (100 ; 100') et le couvercle (200 ; 200') est prévu avec un orifice de guidage (160a, 160b, 180a, 180b; 160a', 160b', 180a', 180b') pour s'interconnecter entre l'orifice (170a, 170b ; 170a', 170b') ou la fente (140a, 140b, 150 ; 140a', 140b', 150') de boîtier et l'extérieur du corps et du couvercle, et
la partie de raccordement (330a, 330b, 330c ; 330a', 330b', 330c') du contact (300a, 300b, 300c ; 300a', 300b', 300c') fait saillie à travers l'orifice de guidage vers l'extérieur du corps et du couvercle.

9. Connecteur étanche selon l'une quelconque des revendications 1 à 8, dans lequel :
au moins l'un parmi le corps (100 ; 100'), le couvercle (200 ; 200') et la partie moulée (400 ; 400') est réalisé avec une résine de polyamide.

10. Connecteur étanche selon l'une quelconque des revendications 1 à 9, comprenant en outre un joint de forme annulaire (500) destiné à s'adapter autour du corps (100 ; 100').

11. Dispositif électronique comprenant le connecteur étanche selon l'une quelconque des revendications 1 à 10.
